# EUROPÄISCHE PATENTSCHRIFT

(11) **EP 2 993 705 B1**
(45) Veröffentlichungstag und Bekanntmachung des Hinweises auf die Patenterteilung: **29.11.2017**
(21) Anmeldenummer: 14003068.5
(22) Anmeldetag: 05.09.2014
(51) Int. Cl.: H01L 31/054, H01L 31/0216, B64D 27/24

(54) **Solarkonzentrator für ein Stratosphären- oder Mesosphärenfluggerät**
Solar concentrator for stratospheric or mesospheric aircraft
Concentrateur solaire pour engin volant stratosphérique ou mesosphérique

(43) Veröffentlichungstag der Anmeldung: 09.03.2016
(73) Patentinhaber: Airbus Defence and Space GmbH, 85521 Ottobrunn (DE)
(72) Erfinder: Steinwandel, Jürgen, 88690 Uhldingen-Mühlhofen (DE); Stückl, Stefan, 80798 München (DE); Stuhlberger, Johannes, 81369 München (DE)

(56) Entgegenhaltungen:
- DE-A1- 19 705 046
- JP-A- H04 111 475
- US-A- 4 687 880
- US-A- 5 089 055
- US-A- 5 501 743
- US-A1- 2009 272 424

## Beschreibung

Die Erfindung betrifft zunächst eine Vorrichtung zur Versorgung eines Stratosphären- oder Mesosphärenfluggeräts mit elektrischer Energie unter Verwendung mindestens einer Solarzelle.

Darüber hinaus hat die Erfindung ein Stratosphären- oder Mesospärenfluggerät mit mindestens einer Solarzelle zur Versorgung mit elektrischer Energie, zum Gegenstand.
Aus dem Stand der Technik sind hochfliegende Plattformen (s. g. HAPS- High Altitude Pseudo Satellites) in vielfältigen Ausführungsformen bekannt, wobei das "Schwerer oder leichter als Luft- Prinzip" zur Anwendung kommen kann. Derartige hochfliegende Plattformen bewegen sich hierbei in Höhen von bis zu 200 km über dem Erdboden und dienen unter anderem als Instrumententräger zur permanenten Erdbeobachtung bei einem im Vergleich zu konventionellen Satelliten deutlich reduzierten technischen Aufwand. Ein Beispiel wird in US 2009/272424 A1 beschrieben. Photovoltaische Vesorgungsvorrichtungen werden ebenfalls in US 5501743 A offenbart. Zur elektrischen Energieversorgung von hochfliegenden Plattformen kommen als primäre Energiequelle vor allem in die Tragflächen integrierte Solarzellen in Betracht. Mittels der Solarzellen werden im Tagbetrieb Akkumulatoren zur Speisung der Antriebsmotoren im Nachtzyklus geladen, so dass die hochfliegende Plattform nahezu unbegrenzte Zeit in der Luft verbleiben kann. Bei den hochfliegenden Plattformen handelt es sich um extreme Leichtbaustrukturen, deren Tragflächen zur Minimierung des Strömungswiderstands in der Regel ein Laminarprofil aufweisen.
Ein Nachteil der bisherigen Energieversorgung von hochfliegenden Plattformen liegt darin, dass die Integration von Solarzellen in die Tragflächen zum einen das Laminarprofil verändert und damit die Aerodynamik nachteilig beeinflusst und zum anderen die Leichtbaustruktur in unvorteilhafter Weise vorrangig im Bereich der Tragflächen zusätzliche Lasten übernehmen muss.
Eine Aufgabe der Erfindung ist es daher, eine elektrische Energieversorgung für hochfliegende Plattformen bzw. Leichtbaustrukturen zu schaffen, die zu keiner nennenswerten mechanischen Belastung der Leichtbaustruktur führt und durch die die Aerodynamik nicht nachteilig beeinflusst wird. Darüber hinaus ist es eine Aufgabe der Erfindung, eine hochfliegende Plattform bzw. eine hochfliegende Leichtbaustruktur mit einer derartigen Energieversorgung anzugeben.

Diese Aufgabe wird durch die Vorrichtung vom Anspruch 1 gelöst, wodurch mindestens ein Strahlungskollektor zum Auffangen von Sonnenstrahlung vorgesehen ist und der mindestens eine Strahlungskollektor über mindestens ein Faserbündel optisch mit mindestens einem Strahlungsemitter verbunden ist, wobei die mindestens eine Solarzelle zur Erzeugung von elektrischer Energie durch den mindestens einen Strahlungsemitter mit der von dem mindestens einen Strahlungskollektor aufgefangenen und durch das mindestens eine Faserbündel weitergeleiteten Sonnenstrahlung bestrahlbar ist. Hierdurch können die Solarzellen z. B. aus den Tragflächen in eine Zentralstruktur der hochfliegenden Leichtbaustruktur bzw. Plattform ausgelagert werden, so dass sich eine mechanische Entlastung der Struktur aufgrund einer günstigeren Gewichtsverteilung ergibt. Darüber hinaus verkürzen sich die elektrischen Leitungswege zu den als elektrische Energiespeicher eingesetzten Akkumulatoren, woraus eine weitere Gewichtseinsparung resultiert. Die Erfindung ermöglicht ferner den problemlosen Einsatz starrer monokristalliner Solarzellen mit hohem Wirkungsgrad, die sich ansonsten kaum ohne Inkaufnahme von aerodynamischen Verlusten und strukturmechanischen Nachteilen in gekrümmte Flächen von z. B. Tragflächen integrieren lassen. Weiterhin kann auch mindestens eine Dünnschichtsolarzelle zum Einsatz kommen, deren Oberflächengeometrie flexibel gestaltbar ist.
Im Fall einer günstigen technischen Weiterbildung ist eine der Sonnenstrahlung zugewandte Auffangfläche des Strahlungskollektors zumindest bereichsweise mit einer Antireflexionsschicht versehen. Hierdurch erhöht sich der energetische Gesamtwirkungsgrad der Vorrichtung, so dass die auftreffende Sonnenstrahlung nahezu vollständig vom Strahlungskollektor aufgenommen werden kann. Die Antireflexionsschicht kann z. B. mit MgF₂ gebildet sein.

Bei einer weiteren vorteilhaften Ausgestaltung ist eine Rückseite des Strahlungskollektors zumindest bereichsweise mit einer Metallschicht versehen. Hierdurch wird ggfls. aus dem Strahlungskollektor aufgrund einer nicht vollständigen Totalreflexion austretende Sonnenstrahlung wieder in den Strahlungskollektor eingekoppelt und steht damit wieder zur Stromerzeugung zur Verfügung. Darüber hinaus hat die Metallschicht bei hinreichender Materialstärke unter Umständen eine strukturell verstärkende Wirkung und aufgrund der guten Wärmeleitfähigkeit von metallischen Werkstoffen kann unter Umständen ein Kühlungseffekt zur Ableitung von entstehender Verlustwärme erzielt werden.

Nach Maßgabe einer günstigen Weiterentwicklung liegt eine Abstrahlfläche des Strahlungsemitters im Wesentlichen vollflächig an der mindestens einen Solarzelle an und eine Rückseite des Strahlungsemitters ist zumindest bereichsweise mit einer Metallschicht versehen. Hierdurch wird die dem Strahlungsemitter über das mindestens eine Faserbündel zugeführte Sonnenstrahlung gleichmäßig verteilt und praktisch verlustfrei in die mindestens eine Solarzelle eingestrahlt.

Nach Maßgabe einer weiteren günstigen Ausgestaltung ist die Abstrahlfläche des Strahlungsemitters gleich oder kleiner als die Auffangfläche des Strahlungskollektors. Hierdurch ist eine Konzentration bzw. eine Erhöhung der Flächenintensität der Sonnenstrahlung realisierbar, so dass die Solarzellenfläche bei gleicher elektrischer Leistung verkleinert werden kann und sich eine weitere Gewichtsreduktion ergibt.

Bei einer weiteren günstigen Fortbildung ist vorgesehen, dass das mindestens eine Faserbündel an mindestens eine Seitenfläche des Strahlungskollektors und an mindestens eine Seitenfläche des Strahlungsemitters optisch angekoppelt ist. Hierdurch erfolgt die Aus- und die Einkopplung der Sonnenstrahlung in einer besonders platzsparenden Weise, die zugleich die Integration des Systems in eine vorhandene Leichtbaustruktur bei geringer Bauhöhe erleichtert.

Bei der Ausgestaltung der Vorrichtung ist vorgesehen, dass der Strahlungskollektor und der Strahlungsemitter jeweils mit mindestens einer faseroptischen Matte gebildet sind. Hierdurch kann zumindest der Strahlungskollektor direkt in einen Laminataufbau der Leichtstruktur, wie z. B. eine Tragfläche oder dergleichen, integriert werden und bildet zumindest einen Teil von dessen strukturmechanischem Aufbau.

Nach Maßgabe der Erfindung sind die faseroptischen Matten jeweils mit einer Vielzahl von insbesondere miteinander verwobenen optischen Fasern aus Glas und/oder Kunststoff gebildet. Hierdurch ist eine verlustarme Aufnahme, Weiterleitung, Verteilung oder Fokussierung der aufgefangenen Sonnenstrahlung möglich. Entsprechend ist das mindestens eine Faserbündel gleichfalls mit optischen Fasern aus Glas und/oder Kunststoff aufgebaut. Die optischen Fasern können parallel zueinander verlaufen, miteinander verdrillt oder miteinander verflochten sein. Darüber hinaus verfügen die optischen Fasern aus Glas oder aus Kunststoff über ein geringes Gewicht und können direkt in einen Kunststofflaminataufbau, wie z. B. CFK oder GFK, integriert werden bzw. diesen sogar zumindest teilweise selbst ausbilden. Entsprechend lässt sich auch das Faserbündel direkt in die Struktur der hochfliegenden Leichtbaustruktur integrieren.

Darüber hinaus wird die erfindungsgemäße Aufgabe durch ein Stratosphären- oder Mesosphärenfluggerät mit mindestens einer Solarzelle zur Versorgung mit elektrischer Energie gelöst.
Dadurch, dass mindestens ein Strahlungskollektor zum Auffangen von Sonnenstrahlung außenliegend angeordnet ist und mindestens ein Strahlungsemitter innenliegend positioniert ist, wobei der mindestens eine Strahlungskollektor mittels mindestens eines Faserbündels optisch mit dem mindestens einen Strahlungsemitter verbunden ist und mittels des mindestens einen Strahlungsemitters die mindestens eine Solarzelle zur Erzeugung von elektrischer Energie bestrahlbar ist, ist eine aerodynamisch und strukturmechanisch optimale Integration einer elektrischen Energieversorgung in eine derartige hochfliegende Leichtbaustruktur auf der Basis von Solarzellen bei einer gleichzeitigen Gewichtsreduktion realisierbar. Der Begriff "außenliegend" definiert im Kontext dieser Beschreibung, dass der mindestens eine Strahlungskollektor außerhalb der Struktur des Fluggeräts, d. h. zumindest bereichsweise in demjenigen Bereich der Oberfläche des Fluggeräts, die der Sonnenstrahlung exponiert ist, angeordnet ist. Dies bedeutet, dass der mindestens eine Strahlungskollektor zumindest teilweise der (Rest-)Atmosphäre bzw. Umgebungseinflüssen direkt ausgesetzt ist und von der Sonnenstrahlung getroffen bzw. beschienen wird. Demgegenüber ist z. B. der "innenliegend" positionierte Strahlungsemitter von der s. g. primären (tragenden) Struktur des Flluggeräts im Wesentlichen allseitig umschlossen, d. h. im Inneren des Stratosphären- oder Mesosphärenfluggeräts angebracht und nicht der umgebenden Sonnenstrahlung sowie äußeren atmosphärischen Einflüssen ausgesetzt.
Nach Maßgabe einer günstigen Ausgestaltung ist mindestens ein Strahlungskollektor im Bereich mindestens einer Oberseite mindestens einer Tragfläche des Fluggeräts angeordnet und mindestens ein Strahlungsemitter und die mindestens eine Solarzelle sind in einem Anschlussbereich der mindestens einen Tragfläche an eine Zentralstruktur des Fluggeräts angeordnet. Infolge der Verlagerung des Strahlungsemitters und der mindestens einen Solarzelle in die Zentralstruktur, insbesondere eine Rumpfzelle, des Fluggeräts ergibt sich eine vorteilhafte Gewichtsverlagerung bei einer zugleich verbesserten Aerodynamik. Darüber hinaus kann der Strahlungskollektor selbst zumindest einen Teil der tragenden Struktur bilden. Der mindestens eine Strahlungskollektor und der mindestens eine Strahlungsemitter sind jeweils mit mindestens einer faseroptischen Matte gebildet. Hierdurch kann die Sonnenstrahlung mittels des Strahlungskollektors aufgefangen, weitergeleitet und konzentriert werden, während die dem Strahlungsemitter mittels des Faserbündels zugeführte Sonnenstrahlung weitergleitet, dispergiert und möglichst gleichmäßig auf die mindestens eine Solarzelle abgestrahlt wird.

Gemäß der Erfindung sind die faseroptischen Matten mit einer Vielzahl von insbesondere miteinander verwobenen optischen Fasern aus Glas und/oder Kunststoff gebildet. Hierdurch ist eine verlustarme Aufnahme, Weiterleitung, Konzentration sowie anschließende Dispersion bzw. gleichmäßige Feinverteilung der Sonnenstrahlung über die mindestens eine Solarzelle hinweg bei einem zugleich geringen Gewicht realisierbar.
Die Integration der faseroptischen Matten des Strahlungskollektors kann z. B. im Bereich einer Rumpfoberseite, dem Höhenleitwerk oder dem Seitenleitwerk erfolgen. Die faseroptischen Matten des Strahlungskollektors können sich in einer theoretisch denkbaren Maximalkonfiguration über eine gesamte, der Sonnenstrahlung ausgesetzte Oberfläche des Fluggeräts hinweg oder in einem Teilbereich hiervon erstrecken. Darüber hinaus haben die zur Integration in das Fluggerät eingewebten Glasfasern und/oder die eingewebten Kunststofffasern neben ihrer Sonnenstrahlungssammel- und -leitungsfunktion eine strukturverstärkende Wirkung. Bei der Dimensionierung der maximalen elektrischen Leistung der mindestens einen Solarzelle des mindestens einen Strahlungskollektors ist ferner eine unter anderem von dem eingesetzten Solarzellentyp abhängige alterungsbedingte Leistungsabnahme zu berücksichtigen, um über die gesamte Einsatzdauer des Fluggeräts hinweg eine ausreichende Versorgung mit elektrischer Energie zu gewährleisten.
In der Zeichnung zeigt:
- Figur 1: eine schematische Darstellung einer erfindungsgemäßen Vorrichtung zur Versorgung eines Stratosphärenfluggeräts, mit elektrischer Energie, und
- Figur 2: eine Prinzipdarstellung eines mit der Vorrichtung ausgerüsteten Fluggeräts.

Die Vorrichtung 10 umfasst unter anderem einen Strahlungskollektor 12, der mittels eines Faserbündels 14 mit einem Strahlungsemitter 16 verbunden ist. Der Strahlungskollektor 12 verfügt hier lediglich exemplarisch über eine plattenförmige Geometrie und beinhaltet als ein wesentliches Element eine faseroptische Matte 18.

Derartige faseroptische Matten sind mit einer gewebten Anordnung von optischen Glas- und/oder Kunststofffasern aufgebaut. Die detaillierte Beschaffenheit derartiger faseroptischer Matten ist dem Fachmann aus dem Stand der Technik geläufig, so dass an dieser Stelle auf eine eingehende Erläuterung der konstruktiven Ausgestaltung verzichtet werden kann. Entsprechendes gilt für den Aufbau des Faserbündels zur optischen Kopplung zwischen dem Strahlungskollektor 12 und dem Strahlungsemitter 16.
Eine der Sonnenstrahlung 20 zugewandte Auffangfläche 22 des Strahlungskollektors 12 bzw. der faseroptischen Matte 18 ist mit einer Antireflexionsschicht 24 versehen, so dass die auftreffende Sonnenstrahlung 20 nahezu vollständig von der faseroptischen Matte 18 aufgenommen, weitergleitet und konzentriert wird. Eine Rückseite 26 des Strahlungskollektors 12 bzw. der faseroptischen Matte 18 ist mit einer Metallschicht 28 versehen, die ggfls. aufgrund unvollständiger Totalreflexion aus der faseroptischen Matte 18 austretende Sonnenstrahlung 20 zurück in die faseroptische Matte 18 spiegelt.
Das Faserbündel 14 ist mit einer Vielzahl von z. B. parallel verlaufenden optischen Glas- oder Kunststofffasern aufgebaut, die alternativ auch miteinander verflochten, verdrillt oder verstrickt sein können.
Wie mit den kleinen schwarzen Pfeilen angedeutet, wird die vom Strahlungskollektor 12 aufgenommene Sonnenstrahlung z. B. über eine Seitenfläche 30 des Strahlungskollektors 12 in das Faserbündel 14 eingekoppelt und von diesem verlustarm bis zum Strahlungsemitter 16 weitergeleitet. Zu diesem Zweck ist die faseroptische Matte 18 derart beschaffen, dass die von ihr aufgenommene Sonnenstrahlung 20 in einem zentralen Bereich der Seitenfläche 30 konzentriert und zur Abgabe bereitgestellt wird.
Der Strahlungsemitter 16 umfasst als eine wesentliche Baugruppe ebenfalls eine faseroptische Matte 40. Eine Seite 42 des Strahlungsemitters 16 bzw. der faseroptischen Matte 40 ist wiederum mit einer Metallschicht 44 versehen. An einer von der Rückseite 42 weggerichteten Abstrahlfläche 46 des Strahlungsemitters 16 bzw. der faseroptischen Matte 40 liegt hingegen mindestens eine Solarzelle 48 bzw. ein mit einer Vielzahl von Solarzellen gebildetes Solarpanel bevorzugt vollflächig, d. h. spaltfrei an. Als Solarzellen kommen bevorzugt hocheffiziente monokristalline Zellen mit einem möglichst hohen elektrischen Wirkungsgrad von bis zu 40 % und einem möglichst breiten Empfindlichkeitsspektrum in Betracht, so dass möglichst viele Wellenlängenanteile in der Sonnenstrahlung 20 für die Stromerzeugung nutzbar sind. Die rückseitige Abstrahlfläche 46 des Strahlungsemitters 16 ist vorzugsweise gleich oder kleiner als die Auffangfläche 22 des Strahlungskollektors 12, so dass eine Konzentration der Sonnenstrahlung 20 möglich ist, die weitere Gewichtseinsparungen möglich macht.
Die vom Strahlungskollektor 12 gesammelte Sonnenstrahlung 20 und über zumindest einen Bereich der Seitenfläche 30 abgegebene Sonnenstrahlung 20 wird über das Faserbündel 14 zumindest bereichsweise in eine Seitenfläche 50 der faseroptischen Matte 40 des Strahlungsemitters 16 eingekoppelt und darin wiederum möglichst gleichmäßig verteilt. Wie mit den kleinen schwarzen Pfeilen angedeutet, wird die Sonnenstrahlung 20 von der faseroptischen Matte 40 des Strahlungsemitters 16 im Idealfall gleichmäßig über die Abstrahlfläche 46 abgestrahlt und trifft sodann auf die mindestens eine Solarzelle 48, in der die teilweise Umwandlung der in der Sonneneinstrahlung 20 enthaltenen Strahlungsenergie in elektrische Energie erfolgt.

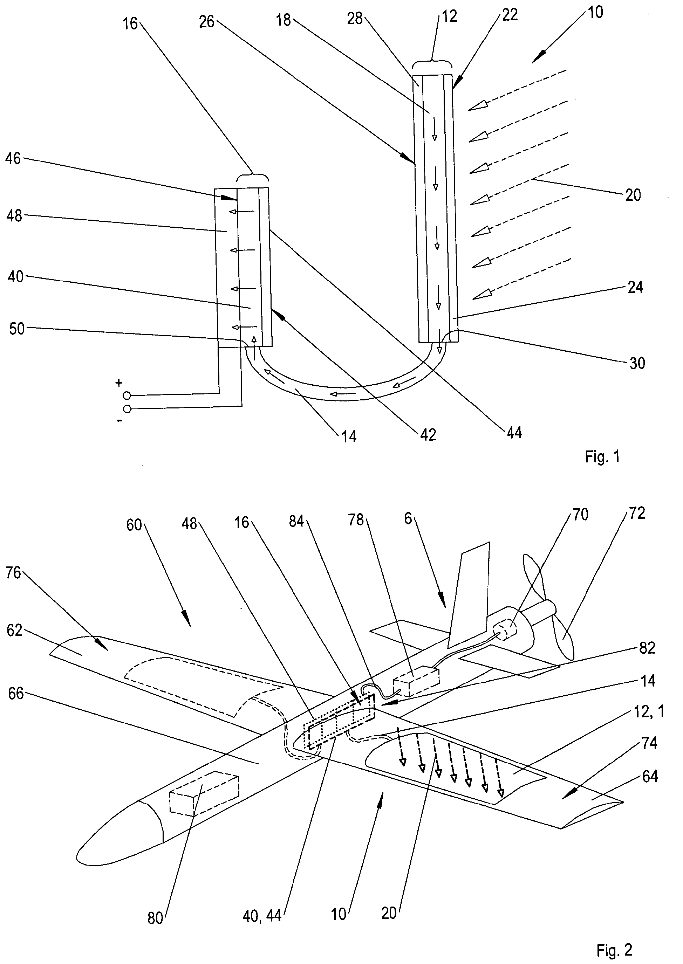

Die Fig. 2 zeigt eine Prinzipdarstellung eines mit der Vorrichtung ausgerüsteten Fluggeräts. Eine hochfliegende, bevorzugt unbemannte Leichtbaustruktur 60, umfasst zwei Tragflächen 62, 64, die seitlich an eine Zentralstruktur 66 bzw. eine Rumpfzelle anschließen. Die beiden Tragflächen 62, 64 sind zur Minimierung des aerodynamischen Strömungswiderstands bevorzugt mit einem Laminarprofil versehen. Weiterhin verfügt die Leichtbaustruktur 60 über ein Leitwerk 68 zur Stabilisierung und Steuerung, sowie beispielsweise über eine von einem Elektromotor 70 angetriebene, hier exemplarisch heckseitig angeordnete Luftschraube 72 zum Vortrieb. Die Leichtbaustruktur 60 ist bevorzugt zumindest teilweise mit glasfaserverstärkten und/oder mit kohlefaserverstärkten Kunststoffmaterialen gefertigt.

Die Leichtbaustruktur 60 ist erfindungsgemäß mit der Vorrichtung 10 von Fig. 1 zur Erzeugung von elektrischer Energie ausgestattet. Hierbei ist aus Gründen der besseren zeichnerischen Übersicht halber lediglich der eine Strahlungskollektor 12 im Bereich einer Oberseite 74 der Tragfläche 64 zum Auffangen der aus dem Weltraum kommenden Sonnenstrahlung 20 als ein integraler Bestandteil derselben integriert, d. h. die faseroptische Matte 18 ist neben ihrer Strahlungssammelfunktion selbst zumindest teilweise ein lasttragender Bestandteil der Tragfläche 64.

Zusätzlich kann ein weiterer, hier lediglich mit einer gestrichelten Linie angedeuteter Strahlungskollektor im Bereich einer Oberseite 76 der anderen Tragfläche 62 in diese integriert und mittels eines weiteren, ebenfalls gestrichelt angedeuteten Faserbündels optisch an den Strahlungsemitter 26 angekoppelt sein. Darüber hinaus kann sich der mindestens eine Strahlungskollektor 12 über eine der Sonnenstrahlung 20 ausgesetzte (Gesamt-)Oberfläche 77 der Leichtbaustruktur 60 hinweg erstrecken.

Alternativ kann ein weiterer, jedoch nicht dargestellter Strahlungsemitter vorgesehen sein, dem ggfls. mindestens eine weitere Solarzelle zugeordnet ist. Beim Anschluss eines weiteren Strahlungskollektors an den einen Strahlungsemitter 16 kann aufgrund der dann erhöhten Energiedichte unter Umständen eine Vergrößerung des Strahlungsemitters 16, insbesondere von dessen Abstrahlfläche 46 und von der Zellenfläche der diesem zugeordneten, mindestens einen Solarzelle 48, erforderlich sein.

Über das Faserbündel 14 gelangt die vom Strahlungskollektor 12 gesammelte Sonnenstrahlung 20 verlustarm zu dem Strahlungsemitter 16 mit der an diesen anliegenden mindestens einen Solarzelle 48, mittels der die Umwandlung der Strahlungsenergie der Sonnenstrahlung 20 in elektrische Energie erfolgt. Die solchermaßen gewonnene elektrische Energie wird bevorzugt für den Nachtbetrieb in einem Akkumulator 78 zwischengespeichert und von dort unter der Kontrolle einer komplexen Flugsteuereinheit 80 zum unbemannten und ggfls. sogar vollautonomen Betrieb der Leichtbaustruktur 60 dem Elektromotor 70 zum Antrieb der Luftschraube 72 zugeleitet.

Lediglich exemplarisch befindet sich der Strahlungskollektor 12 hier in der vorderen Tragfläche 64, während der Strahlungsemitter 16 zusammen mit der zugehörigen mindestens einen Solarzelle 48 z. B. in einem Anschlussbereich 82 zwischen der Tragfläche 64 und der Zentralstruktur 66 angeordnet ist.

Grundsätzlich ergeben sich durch die erfindungsgemäße räumliche Trennung zwischen dem Ort der Aufnahme der Sonnenstrahlung 20 und des Ortes, in dem die Konvertierung der Sonnenstrahlungsenergie in elektrische Energie erfolgt, eine Vielzahl von Einbauvariationen der Vorrichtung 10 in eine derartige, hochfliegende Leichtbaustruktur 60.

Durch die erfindungsgemäße Vorrichtung 10 bzw. den Solargenerator mit ortsverschiedener Sammlung und elektrischer Konvertierung der Sonnenstrahlung 20 verbessern sich die aerodynamischen Eigenschaften der Tragflächen 62, 64, da das Laminatprofil nicht mehr durch Solarzellen gestört wird.

Darüber hinaus ergeben sich beträchtliche strukturelle Vorteile, da der Strahlungskollektor 12 selbst zumindest einen Teil der lasttragenden Struktur der Tragfläche 64 bildet. Ferner verkürzt sich z. B. eine Länge einer metallischen, elektrischen Verbindungsleitung 84 zwischen der mindestens einen Solarzelle 48 und dem Akkumulator 74, da erfindungsgemäß der Ort der Energiekonvertierung - in Gestalt der mindestens einen Solarzelle 48 - räumlich nahe an den Akkumulator 74 heranrückt, was zu einer weiteren Gewichtsreduzierung führt. Die Erfindung ist hierbei nicht auf Fluggeräte nach dem Prinzip "Schwerer als Luft" beschränkt zu sehen, sondern kann gleichermaßen bei Fluggeräten mit alternativen Auftriebsprinzipien, wie z. B. starren Luftschiffen, halbstarren Luftschiffen oder Prallluftschiffen etc. in wirkungsvoller Weise Anwendung finden.

Die Erfindung betrifft eine Vorrichtung 10 zur Versorgung eines Stratosphären- oder Mesosphärenfluggeräts mit elektrischer Energie unter Verwendung mindestens einer Solarzelle 48. Erfindungsgemäß ist mindestens ein Strahlungskollektor 12 zum Auffangen von Sonnenstrahlung 20 vorgesehen und der mindestens eine Strahlungskollektor 12 ist über mindestens ein Faserbündel 14 optisch mit mindestens einem Strahlungsemitter 16 verbunden, wobei die mindestens eine Solarzelle 48 zur Erzeugung von elektrischer Energie durch den mindestens einen Strahlungsemitter 16 mit der von dem mindestens einen Strahlungskollektor 12 aufgefangenen und durch das mindestens eine Faserbündel 14 weitergeleiteten Sonnenstrahlung 20 bestrahlbar ist. Dadurch, dass die Sonnenstrahlung 20 an einem Ort aufgefangen und an einem hiervon verschiedenen Ort in elektrische Energie konvertiert wird, lassen sich aerodynamische sowie strukturmechanische Vorteile erzielen, die unteren anderem eine signifikante Gewichtsreduktion eines mit der Vorrichtung 10 ausgestatteten Fluggeräts ermöglichen. Darüber hinaus hat die Erfindung ein Fluggerät 60 zum Gegenstand.

**Bezugszeichenliste**

| | | | |
|---|---|---|---|
| 10. | Vorrichtung | 74. | Oberseite (Tragfläche) |
| 12. | Strahlungskollektor | 76. | Oberseite (Tragfläche) |
| 14. | Faserbündel | 77. | Oberfläche |
| 16. | Strahlungsemitter | 78. | Akkumulator |
| 18. | faseroptische Matte | 80. | Flugsteuereinheit |
| 20. | Sonnenstrahlung | 82. | Anschlussbereich |
| 22. | Auffangfläche | 84. | elektr. Verbindungsleitung |
| 24. | Antireflexionsschicht | | |
| 26. | Rückseite (Strahlungskollektor) | | |
| 28. | Metallschicht | | |
| 30. | Seitenfläche (Strahlungskoll.) | | |
| 40. | faseroptische Matte | | |
| 42. | Seite (Strahlungsemitter) | | |
| 44. | Metallschicht | | |
| 46. | Abstrahlfläche | | |
| 48. | Solarzelle | | |
| 50. | Seitenfläche (Strahlungsemitter) | | |
| 60. | Leichtbaustruktur | | |
| 62. | Tragfläche | | |
| 64. | Tragfläche | | |
| 66. | Zentralstruktur | | |
| 68. | Leitwerk | | |
| 70. | Elektromotor | | |
| 72. | Luftschraube | | |

## Patentansprüche

1. Vorrichtung (10) zur Versorgung eines Stratosphären- oder Mesosphärenfluggeräts, mit elektrischer Energie unter Verwendung mindestens einer Solarzelle (48), wobei mindestens ein Strahlungskollektor (12) zum Auffangen von Sonnenstrahlung (20) vorgesehen ist und der mindestens eine Strahlungskollektor (12) über mindestens ein Faserbündel (14) optisch mit mindestens einem Strahlungsemitter (16) verbunden ist, wobei die mindestens eine Solarzelle (48) zur Erzeugung von elektrischer Energie durch den mindestens einen Strahlungsemitter (16) mit der von dem mindestens einen Strahlungskollektor (12) aufgefangenen und durch das mindestens eine Faserbündel (14) weitergeleiteten Sonnenstrahlung (20) bestrahlbar ist, **dadurch gekennzeichnet, dass** der Strahlungskollektor (12) und der Strahlungsemitter (16) jeweils mit mindestens einer faseroptischen Matte (18, 40) gebildet sind, wobei die faseroptischen Matten (18, 40) jeweils mit einer Vielzahl von miteinander verwobenen optischen Fasern aus Glas und/oder Kunststoff gebildet sind.

2. Vorrichtung (10) nach Anspruch 1, **dadurch gekennzeichnet, dass** eine der Sonnenstrahlung (20) zugewandte Auffangfläche (22) des Strahlungskollektors (12) zumindest bereichsweise mit einer Antireflexionsschicht (24) versehen ist.

3. Vorrichtung (10) nach Anspruch 1 oder 2, **dadurch gekennzeichnet, dass** eine Rückseite (26) des Strahlungskollektors (12) zumindest bereichsweise mit einer Metallschicht (28) versehen ist.

4. Vorrichtung (10) nach einem der Ansprüche 1 bis 3, **dadurch gekennzeichnet, dass** eine Abstrahlfläche (46) des Strahlungsemitters (16) im Wesentlichen vollflächig an der mindestens einen Solarzelle (48) anliegt und eine Rückseite (42) des Strahlungsemitters (16) zumindest bereichsweise mit einer Metallschicht (44) versehen ist.

5. Vorrichtung (10) nach einem der Ansprüche 1 bis 4, **dadurch gekennzeichnet, dass** die Abstrahlfläche (46) des Strahlungsemitters (16) gleich oder kleiner als die Auffangfläche (22) des Strahlungskollektors (12) ist.

6. Vorrichtung (10) nach Anspruch 5, **dadurch gekennzeichnet, dass** das mindestens eine Faserbündel (14) an mindestens eine Seitenfläche (30) des Strahlungskollektors (12) und an mindestens eine Seitenfläche (50) des Strahlungsemitters (16) optisch angekoppelt ist.

7. Stratosphären- oder Mesosphärenfluggerät, mit mindestens einer Solarzelle (48) zur Versorgung mit elektrischer Energie, wobei mindestens ein Strahlungskollektor (12) zum Auffangen von Sonnenstrahlung (20) außenliegend angeordnet ist und mindestens ein Strahlungsemitter (16) innenliegend positioniert ist, wobei der mindestens eine Strahlungskollektor (12) mittels mindestens eines Faserbündels (14) optisch mit dem mindestens einen Strahlungsemitter (16) verbunden ist und mittels des mindestens einen Strahlungsemitters (16) die mindestens eine Solarzelle (48) zur Erzeugung von elektrischer Energie bestrahlbar ist, **dadurch gekennzeichnet, dass** der mindestens eine Strahlungskollektor (12) und der mindestens eine Strahlungsemitter (16) jeweils mit mindestens einer faseroptischen Matte (18, 40) gebildet sind, wobei die faseroptischen Matten (18, 40) mit einer Vielzahl von miteinander verwobenen optischen Fasern aus Glas und/oder Kunststoff gebildet sind.

8. Stratosphären- oder Mesosphärenfluggerät nach Anspruch 7, **dadurch gekennzeichnet, dass** mindestens ein Strahlungskollektor (12) im Bereich mindestens einer Oberseite (74, 76) mindestens einer Tragfläche (62, 64) des Stratosphären- oder Mesosphärenfluggeräts und mindestens ein Strahlungsemitter (16) und die mindestens eine Solarzelle (48) in einem Anschlussbereich (82) der mindestens einen Tragfläche (62, 64) an eine Zentralstruktur (66) des Stratosphären- oder Mesosphärenfluggeräts angeordnet sind.

## Claims

1. Device (10) for providing a stratospheric or mesospheric flying apparatus with electrical energy by the use of at least one solar cell (48), wherein at least one solar collector (12) is provided for capturing solar radiation (20) and the at least one solar collector (12) is optically connected via at least one fibre bundle (14) to at least one radiation emitter (16), wherein the at least one solar cell (48) for generating electrical energy can be irradiated by means of the at least one radiation emitter (16) with the solar radiation (20) captured by means of the at least one solar collector (12) and transferred by means of the at least one fibre bundle (14), **characterised in that** the solar collector (12) and the radiation emitter (16) respectively are constructed with at least one fibre-optic mat (18, 40), said fibre-optic mats (18, 40) respectively being constructed from a plurality of interwoven optical fibres of glass and/or plastic material.

2. Device (10) according to claim 1, **characterised in that** a collecting surface (22) of the solar collector (12) is provided facing the solar radiation (20) with, at least regionally, an anti-reflective layer (24).

3. Device (10) according to claim 1 oder claim 2, **characterised in that** a rear face (26) of the solar collector (12) is provided, at least regionally, with a metal coating (28).

4. Device (10) according to any one of claims 1 to 3, **characterised in that** an emitting surface (46) of the radiation emitter (16) abuts the at least one solar cell (48) substantially across its full surface, and one rear face (42) of the radiation emitter (16) is provided, at least regionally, with a metal coating (44).

5. Device (10) according to any one of claims 1 to 4, **characterised in that** the emitting surface (46) of the radition emitter (16) is equal in area to or smaller than the collecting surface (22) of the solar collector (12).

6. Device (10) according to claim 5, **characterised in that** the at least one fibre bundle (14) is optically coupled to at least one side face (30) of the solar collector (12) and to at least one side face (50) of the radiation emitter (16).

7. Stratospheric or mesospheric flying apparatus, with at least one solar cell (48) for supplying electrical energy, wherein at least one solar collector (12) for capturing solar radiation (20) is arranged externally and at least one radiation emitter (16) is positioned internally, wherein the at least one solar collector (12) is optically connected to the at least one radiation emitter (16) by means of at least one fibre bundle (14) and the at least one solar cell (48) for generating electrical energy can be irradiated by means of the at least one radiation emitter (16), **characterised in that** the at least one solar collector (12) and the at least one radiation emitter (16) respectively are formed with at least one fibre-optic mat (18, 40), said fibre-optic mats (18, 40) being constructed from a plurality of interwoven optical fibres of glass and/or plastic material.

8. Stratospheric or mesospheric flying apparatus according to claim 7, **characterised in that** at least one solar collector (12) in the region of at least one upper face (74, 76) of at least one supporting surface (62, 64) of the stratospheric or mesospheric flying apparatus and at least one radiation emitter (16) and the at least one solar cell (48) are arranged in a connecting region (82) of the at least one supporting surface (62, 64) connecting to a central structure (66) of the stratospheric or mesospheric flying apparatus.

## Revendications

1. Dispositif (10) destiné à l'alimentation d'un engin volant stratosphérique ou mésosphérique en énergie électrique au moyen d'au moins une cellule solaire (48), au moins un collecteur de rayonnement (12) étant prévu pour capter le rayonnement solaire (20) et l'au moins un collecteur de rayonnement (12) étant relié de manière optique à au moins un émetteur de rayonnement (16) par le biais d'au moins un faisceau de fibres (14), l'au moins une cellule solaire (48) pouvant être exposée par l'au moins un émetteur de rayonnement (16) au rayonnement solaire (20) capté par l'au moins un collecteur de rayonnement (12) et transféré par l'au moins un faisceau de fibres (14) pour générer de l'énergie électrique, **caractérisé en ce que** le collecteur de rayonnement (12) et l'émetteur de rayonnement (16) sont formés respectivement avec au moins un tapis de fibres optiques (18, 40), les tapis de fibres optiques (18, 40) étant formés respectivement avec une pluralité de fibres optiques en verre et/ou matière plastique tissées ensemble.

2. Dispositif (10) selon la revendication 1, **caractérisé en ce qu'**une surface de captage (22) du collecteur de rayonnement (12) qui fait face au rayonnement solaire (20) est pourvue au moins sur certaines parties d'une couche antireflet (24).

3. Dispositif (10) selon la revendication 1 ou 2, **caractérisé en ce qu'**une face arrière (26) du collecteur de rayonnement (12) est pourvue au moins sur certaines parties d'une couche métallique (28).

4. Dispositif (10) selon l'une des revendications 1 à 3, **caractérisé en ce qu'**une surface d'émission (46) de l'émetteur de rayonnement (16) est contiguë sensiblement sur toute sa surface à l'au moins une cellule solaire (48) et une face arrière (42) de l'émetteur de rayonnement (16) est pourvue au moins sur certaines parties d'une couche métallique (44).

5. Dispositif (10) selon l'une des revendications 1 à 4, **caractérisé en ce que** la surface d'émission (46) de l'émetteur de rayonnement (16) est égale ou inférieure à la surface de captage (22) du collecteur de rayonnement (12) .

6. Dispositif (10) selon la revendication 5, **caractérisé en ce que** l'au moins un faisceau de fibres (14) est couplé de manière optique à au moins une surface latérale (30) du collecteur de rayonnement (12) et à au moins une surface latérale (50) de l'émetteur de rayonnement (16).

7. Engin volant stratosphérique ou mésosphérique, comprenant au moins une cellule solaire (48) destinée à l'alimentation en énergie électrique, au moins un collecteur de rayonnement (12) destiné au captage de rayonnement solaire (20) étant disposé à l'extérieur et au moins un émetteur de rayonnement (16) étant positionné à l'intérieur, l'au moins un collecteur de rayonnement (12) étant relié de manière optique à l'au moins un émetteur de rayonnement (16) au moyen d'au moins un faisceau de fibres (14) et l'au moins une cellule solaire (48) pouvant être exposée au rayonnement au moyen de l'au moins un émetteur de rayonnement (16) pour générer de l'énergie électrique, **caractérisé en ce que** l'au moins un collecteur de rayonnement (12) et l'au moins un émetteur de rayonnement (16) sont formés respectivement avec au moins un tapis de fibres optiques (18, 40), les tapis de fibres optiques (18, 40) étant formés avec une pluralité de fibres optiques en verre et/ou matière plastique tissées ensemble.

8. Engin volant stratosphérique ou mésosphérique selon la revendication 7, **caractérisé en ce qu'**au moins un collecteur de rayonnement (12) est disposé dans la zone d'au moins une face supérieure (74, 76) d'au moins une surface portante (62, 64) de l'engin volant stratosphérique ou mésosphérique et au moins un émetteur de rayonnement (16) et l'au moins une cellule solaire (48) sont disposés dans une zone de raccord (82) de l'au moins une surface portante (62, 64) à une structure centrale (66) de l'engin volant stratosphérique ou mésosphérique.
